# EUROPEAN PATENT SPECIFICATION

(11) **EP 0 374 842 B1**
(45) Date of publication and mention of the grant of the patent: **29.11.1995**
(21) Application number: 89123470.0
(22) Date of filing: 19.12.1989
(51) Int. Cl.: H01L 27/02

(54) **Semiconductor integrated circuit device of standard cell system**
Integrierte Halbleiterschaltungsanordnung, die aus einem Sytem von Standardzellen besteht
Dispositif de circuit intégré semi-conducteur du type à cellule standard

(30) Priority: 20.12.1988 JP 321147/88
(43) Date of publication of application: 27.06.1990
(73) Proprietor: KABUSHIKI KAISHA TOSHIBA, Kawasaki-shi, Kanagawa-ken 210 (JP); TOSHIBA MICRO-ELECTRONICS CORPORATION, Kawasaki-ku, Kawasaki-shi (JP)
(72) Inventor: Noda, Makoto c/o Intellectual Property Division, Minato-ku Tokyo 105 (JP); Suda, Kazuhiro c/o Intellectual Property Division, Minato-ku Tokyo 105 (JP)
(74) Representative: Lehn, Werner, Dipl.-Ing.

(56) References cited:
- EP-A- 0 177 336
- IEEE JOURNAL OF SOLID-STATE CIRCUITS, vol. SC-21, no. 1, February 1986, IEEE, New York, US ; W.S. SONG et al. : "Power distribution techniques for VLSI circuits"

## Description

The present invention relates to a semiconductor device and, more particularly, to a semiconductor integrated circuit device of a standard cell system having power supply lines improved using three or more wiring layers.

In recent years, micropatterning of elements has been rapidly developed as a semiconductor process technique is improved, and the number of elements integrated in one chip has been increased. In proportion to this, a period required for designing a large scale integrated circuit is undesirably increased. In order to shorten the designing period against an increase in scale of integrated circuits, a method of designing a standard cell system has been widely employed.

When an integrated circuit is designed according to a standard cell, a cell library including basic gates (such as an inverter, a NAND gate, and a flip-flop) pattern-designed in advance is used, and cells in the cell library are automatically arranged and wired by a computer in accordance with logical net list of the integrated circuit to obtain a desired layout of the integrated circuit. As described above, this design method for an integrated circuit according to the standard cell system has a feature that a period required for a layout is extremely short because cells designed in advance and registered as a cell library are used, and because a wiring operation is automatically performed by the computer.

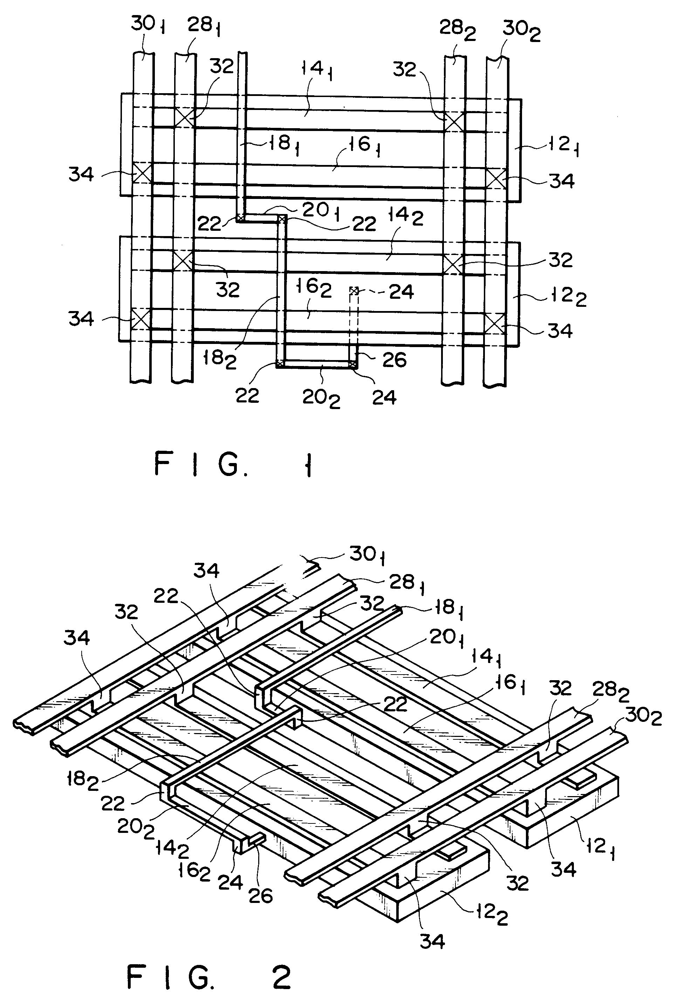

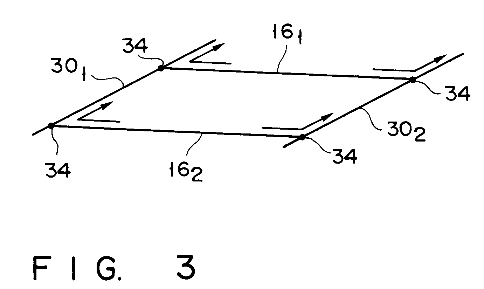

Figs. 1 and 2 show a semiconductor integrated circuit device of a standard cell system according to the prior art, in which Fig. 1 is a plan view, and Fig. 2 is a perspective view of the device in Fig. 1. A plurality of cell arrays which are designed in advance are aligned by a computer in accordance with logical connection data. Spaces between the cell arrays serve as wiring channels, and the cells are wired utilizing the wiring channels, thus constituting a predetermined integrated circuits. Only two standard cell arrays 12₁ and 12₂ are shown in Figs. 1 and 2, for the sake of descriptive simplicity.

In this integrated circuit, a Vcc power supply line for supplying a power supply voltage to each standard cell in the standard cell arrays 12₁ and 12₂, and a GND power supply line to be grounded are arranged as follows.

When standard cells are arranged in one line to constitute a cell array, Vcc and GND power supply lines in a first aluminum (Aℓ) layer which are designed in advance in the respective standard cells are arranged such that the Vcc power supply lines of the adjacent standard cells are connected to each other, and the GND power supply lines of the adjacent standard cells are also connected to each other. In Fig. 1, the Vcc and GND power supply lines in the standard cells are connected in the cell arrays 12₁ and 12₂ to form Vcc power supply lines 14₁ and 14₂ in the cell arrays, and GND power supply lines 16₁ and 16₂ in the cell arrays.

Signal lines are wired to the standard cells as follows. For example, a second aluminum (Aℓ) layer is formed first signal lines 18₁ and 18₂ in a direction perpendicular to the Vcc power supply lines 14₁ and 14₂ and the GND power supply lines 16₁ and 16₂. The first Aℓ layer is formed second signal lines 20₁ and 20₂ along the standard cell arrays 12₁ and 12₂. The second signals lines 20₁ and 20₂ are connected to the first signal lines 18₁ and 18₂ through via holes 22. The second signal line 20₂ is connected to a polysilicon wiring layer 26 through a contact hole 24. The polysilicon wiring layer 26 is connected to one of the standard cells having a predetermined logical function. A supply bus for supplying a power supply voltage is arranged to operate the standard cells in the standard cell arrays 12₁ and 12₂. More specifically, the second Aℓ layer is formed Vcc power supply buses 28₂ and 28₂ and GND power supply buses 30₁ and 30₂ -- all mode from the second Aℓ layer -- are arranged in a direction perpendicular to the Vcc power supply lines 14₁ and 14₂ and the GND power supply lines 16₁ and 16₂. These buses 28₁, 28₂, 30₁, and 30₂ are connected to the Vcc power supply lines 14₁ and 14₂ and the GND power supply lines 16₁ and 16₂ at the both ends thereof through via holes 32 and 34.

A current path of the semiconductor integrated circuit device of the standard cell system with the above arrangement is schematically shown in Fig. 3. In Fig. 3, a current from, e.g., the GND power supply line 16₂ is supplied to the GND power supply buses 30₁ and 30₂ through the via holes 34, as indicated by arrows. Similarly, a current from the GND power supply line 16₁ is supplied to the GND power supply buses 30₁ and 30₂ through the via holes 34.

In the above-mentioned integrated circuit of a standard cell system according to the prior art, when a large scale circuit is arranged, the number of cells arranged in one cell array is increased, and a current which flows through the power supply lines in the cell array is increased, thus causing electromigration. Since the width of each power supply line arranged in the cell is designed in advance and fixed, the number of cells arranged in one cell array is limited so that the current has an allowable density or less of a current which can flow through the power supply line.

When a high-speed operation for decreasing the scale of an integrated circuit is achieved by a scaling operation using a designed standard cell library, the width of the power supply line in the cell array is decreased, and hence a current density of the power supply line is increased, thus causing electromigration.

Note that the electromigration is a phenomenon that a void or a hillock is formed in a metal layer when metal ions in the metal wiring layers are moved under the condition of a large current density, thus finally causing disconnection or short-circuiting of the lines. A service life of each line is adversely affected, and a service life of the integrated circuit device is shortened.

In order to solve the above problem, each line must be reinforced to withstand a large current density. For example, when the widths (patterns) of the Vcc power supply buses 28₁ and 28₂ and the GND power supply buses 30₁ and 30₂ arranged on the standard cell arrays 12₁ and 12₂ are increased, the above problem can be solved.

However, if the widths of the Vcc power supply lines 14₁ and 14₂ and the GND power supply lines 16₁ and 16₂ arranged in the standard cell arrays 12₁ and 12₂ are similarly increased, logic patterns in the standard cells are adversely affected. More specifically, when the pattern is made broader, the standard cells will become larger, inevitably reducing the integration density of the circuit. An increase in the width of these lines is a bar to the enhancement of the integration density.

EP-A- 0177336 describes a standard cell system comprising a plurality of logic cells as well as first and second power supply lines which are perpendicular to each other. A third power supply line is described which is perpendicular to the first power supply line.

The article in IEEE Journal of Solid State Circuits SC-21(1), page 150-156 (1986) entitled "Power distribution techniques for VLSI Circuits" by w. S. Song and L.A. Glasser describes a 3-layer wiring for a VLSI circuit in which first, second and third wiring layers are perpendicular to each other.

It is, therefore, an object of the present invention to provide a high-integration, high-reliability semiconductor integrated circuit device having a long circuit life, which can minimize an adverse effect due to electromigration caused by an increase in current density in wiring layers upon micropatterning of the integrated circuit.

The objects of the invention are solved by a semiconductor integrated circuit device of a standard cell system, comprising a cell array constituted by a linear arrangement of a plurality of cells having a predetermined unit logical function in a semiconductor substrate; a first power supply line connected to each of said cells to supply a power supply voltage to said each cell in said cell array, and formed of a first conductor layer extending in a first direction along said cell array; a second power supply line electrically connected to said first power supply line and formed of a second conductor layer on said first power supply line extending in a second direction perpendicular to said first power supply line; a third power supply line electrically connected to said first power supply line to supply said power supply voltage to each of said cells in said cell array, and formed of a third conductor layer on said second conductor layer extending in a third direction identical to said first direction; a first via hole connecting said first and second power supply lines, arranged at an end portion of said cell array and a second via hole connecting said first and third power supply lines arranged at a central portion of said cell array; wherein said cell array includes at least one dummy cell without a predetermined unit logical function and said second via hole is arranged above said dummy cell.

These and other features and advantages of the present invention will become more apparent from the following detailed description of exemplary embodiments illustrated in the accompanying drawings in which:
Figs. 1 and 2 show a semiconductor integrated circuit device of a standard cell system according to a prior art, in which Fig. 1 is a plan view, and Fig. 2 is a three-dimensional perspective view of the device in Fig. 1;
Fig. 3 is a schematic view showing a current path of the semiconductor integrated circuit device of the prior art shown in Figs. 1 and 2;
Figs. 4 and 5 show a semiconductor integrated circuit device of a standard cell system, in which Fig. 4 is a plan view, and Fig. 5 is a three-dimensional perspective view showing the device in Fig. 4;
Fig. 6 is a schematic view showing the semiconductor integrated circuit device shown in Figs. 4 and 5;
Fig. 7 is a three-dimensional perspective view of a semiconductor integrated circuit device of a standard cell system ; and
Figs. 8 and 9 show a semiconductor integrated circuit device of a standard cell system according to an embodiment of the present invention, in which Fig. 8 is a plan view, and Fig. 9 is a three-dimensional perspective view of the device in Fig. 8.

A semiconductor device according to preferred embodiments of the present invention will be described hereinafter with reference to the accompanying drawings. Note that the same reference numerals in embodiments denote the same elements as in the above-mentioned prior art, and a description thereof will be omitted.

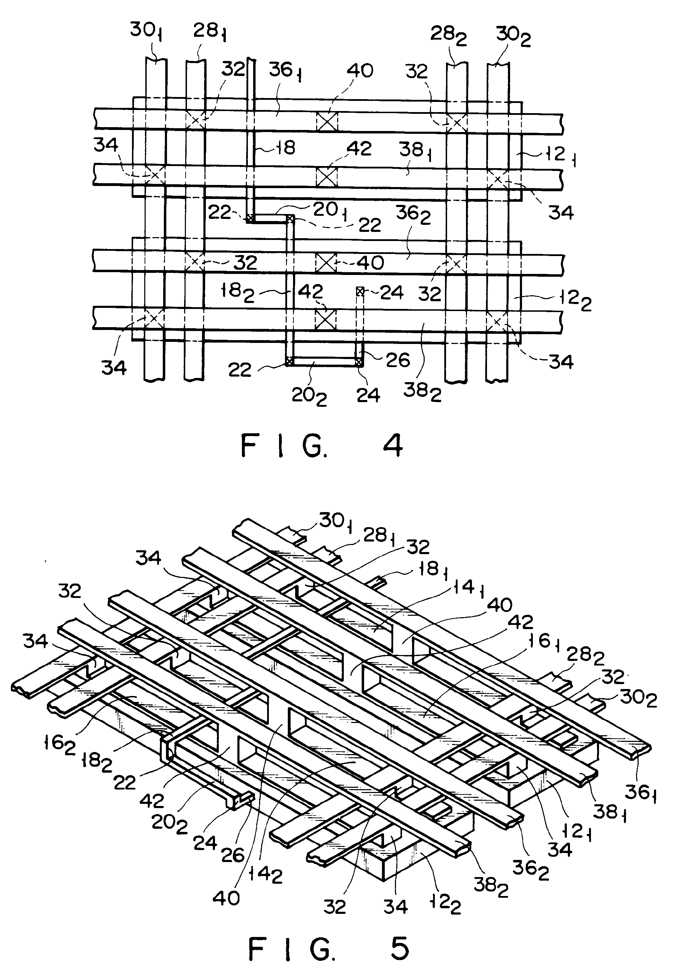

Fig. 4 is a plan view of a semiconductor integrated circuit device of a standard cell system and Fig.5 is a three-dimensional perspective view showing the device in Fig. 4.

The layout of the standard cell system is characterized in that the cells are arranged in a plurality of columns in accordance with cell-connection data, thus forming standard cell arrays. Those regions between any two adjacent arrays is used as a wiring channel. Conductors are formed on the wiring channels, connecting the cells of one array to those of any other array, thus forming logic circuits. For simplicity, only two arrays 12₁ and 12₂ of standard cells are illustrated in Figs. 4 and 5.

In this integrated circuit, vcc power supply supply lines for supplying a power supply voltage to operate the standard cells in the standard cell arrays 12₁ and 12₂, and GND power supply lines to be grounded have the structures described below. In the standard cell arrays 12₁ and 12₂, a first aluminum (Aℓ) layer is patterned into a predetermined shape to form prospective Vcc and GND power supply lines. When the standard cells are arranged, the prospective Vcc and GND power supply lines patterned into the predetermined shapes in each standard cell are connected to each other. In other words, by arranging the standard cells, first Vcc power supply lines 14₁ and 14₂, and first GND power supply lines 16₁ and 16₂ are formed in the first Aℓ layer. Note that the first Aℓ layer is arranged to elongate in a horizontal direction in Fig. 4.

Signal wiring layers connected to each standard cell are constituted by the first Aℓ layer and a second aluminum (Aℓ) layer perpendicular to the first Aℓ layer. For example, the second Aℓ layer is patterned to form first signal lines 18₁ and 18₂ to be perpendicular to the first Vcc power supply lines 14₁ and 14₂ and the first GND power supply lines 16₁ and 16₂. The first Aℓ layer is patterned to form second signal lines 20₁ and 20₂ along the standard cell arrays 12₁ and 12₂. The second signal lines 20₁ and 20₂ are connected to the first signal lines 18₁ and 18₂ through via holes 22.

The first signal lines 18₁ and 18₂ are connected to a polysilicon wiring layer 26 through a contact hole 24. The polysilicon wiring layer 26 is connected to one of the standard cells (one standard cell in the standard cell array 12₂: not shown) having a predetermined logical function. Power supply buses 28₁, 28₂, 30₁, and 30₂ (to be described later) are used as supply buses for supplying a power supply voltage to operate the standard cells in the standard cell arrays 12₁ and 12₂. More specifically, the second Aℓ layer is arranged in a direction perpendicular to, e.g., the first Vcc power supply lines 14₁ and 14₂ and the first GND power supply lines 16₁ and 16₂ to form the Vcc power supply buses 28₁ and 28₂ and the GND power supply buses 30₁ and 30₂. These buses are connected to the first Vcc power supply lines 14₁ and 14₂ and the first GND power supply lines 16₁ and 16₂ at their both ends through via holes 32 and 34.

A third aluminum (Aℓ) layer is patterned to form second power supply lines on the first Vcc power supply lines 14₁ and 14₂ and the first GND power supply lines 16₁ and 16₂ which are formed of the first Aℓ layer in the above-mentioned standard cell arrays 12₁ and 12₂. In other words, second Vcc power supply lines 36₁ and 36₂ are formed on the first Vcc power supply lines 14₁ and 14₂ from the first layer Aℓ, and second GND power supply lines 38₁ and 38₂ are formed on the first GND power supply lines 16₁ and 16₂, also from the first layer Aℓ so that those lines from an uppermost layer. In this case, the second Vcc power supply lines 36₁ and 36₂ extend along the first Vcc power supply lines 14₁ and 14₂, and the second GND power supply lines 38₁ and 38₂ extend along the first GND power supply lines 16₁ and 16₂.

The first Vcc power supply lines 14₁ and 14₂ are connected to the second Vcc power supply lines 36₁ and 36₂ through via holes 40. Similarly, the first GND power supply lines 16₁ and 16₂ are connected to the second GND power supply lines 38₁ and 38₂ through via holes 42. The via hole 40 is located at a substantially center portion of the standard cell array 12₁, and the via hole 42 is located at a substantially center portion of the standard cell array 12₂. At this time, the first signal lines 18₁ and 18₂ formed of the second Aℓ layer are not arranged below the via holes 40 and 42. Note that a plurality of via holes 40 and 42 may be arranged at positions to connect the first Aℓ layer to the third Aℓ layer.

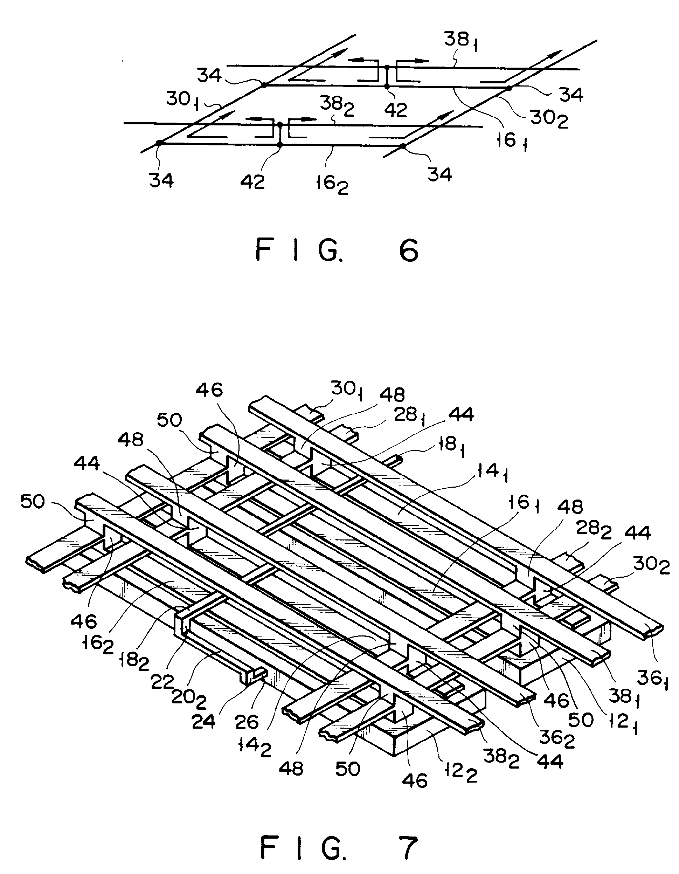

Fig. 6 is a schematic view showing a current path of the above semiconductor integrated circuit device shown in Figs. 4 and 5. In Fig. 6, for example, a current from the first GND power supply lines 16₁ and 16₂ is supplied to the GND power supply buses 30₁ and 30₂ through the via holes 34, and is supplied to the second GND power supply lines 38₁ and 38₂ through the via holes 42, as indicated by arrows.

According to the semiconductor integrated circuit device with the above arrangement, therefore, the second Vcc power supply lines 36₁ and 36₂ and the second GND power supply lines 38₁ and 38₂ are connected to the first Vcc power supply lines 14₁ and 14₂ and the first GND power supply lines 16₁ and 16₂ in the standard cell arrays 12₁ and 12₂, respectively, and hence a current density in the first Vcc power supply lines 14₁ and 14₂, and that in the first GND power supply lines 16₁ and 16₂ can be decreased. Therefore, in the metal layers which constitute these lines, an adverse effect due to electromigration can be suppressed, thus extending a life of each line. Therefore, there is provided a high-integration, high-reliability semiconductor integrated circuit device having a long circuit life.

Since the second Vcc and GND power supply lines of the third Aℓ layer are formed on the standard cell array along the first Vcc and GND power supply lines in the standard cell array, formation of the first signal lines of the second Aℓ layer arranged on the standard cell array in a direction different from the above direction is not interfered. In addition, the second signal lines can be formed using the third Aℓ layer.

Although the via holes are directly formed from the first Aℓ layer to the third Aℓ layer the via holes can be formed as follows.

More specifically, as shown in Fig. 7 after first via holes 44 and 46 are formed on first Vcc power supply lines 14₁ and 14₂ and first GND power supply lines 16₁ and 16₂, Vcc power supply buses 28₁ and 28₂ and GND power supply buses 30₁ and 30₂ are formed as a second Aℓ layer in a direction perpendicular to the first Vcc power supply lines 14₁ and 14₂ and the first GND power supply lines 16₁ and 16₂. Then, second via holes 48 and 50 are formed on the Vcc power supply buses 28₁ and 28₂ and the GND power supply buses 30₁ and 30₂. After the second via holes 48 and 50 are formed, second Vcc power supply lines 36₁ and 36₂ and second GND power supply lines 38₁ and 38₂ are formed above the first Vcc power supply lines 14₁ and 14₂ and the first GND power supply lines 16₁ and 16₂ as a third Aℓ layer in a direction perpendicular to the Vcc power supply buses 28₁ and 28₂ and the GND power supply buses 30₁ and 30₂, i.e., along the first Vcc power supply lines 14₁ and 14₂ and the first GND power supply lines 16₁ and 16₂. Thus, the first Aℓ layer may be connected to the third Aℓ layer through the second Aℓ layer.

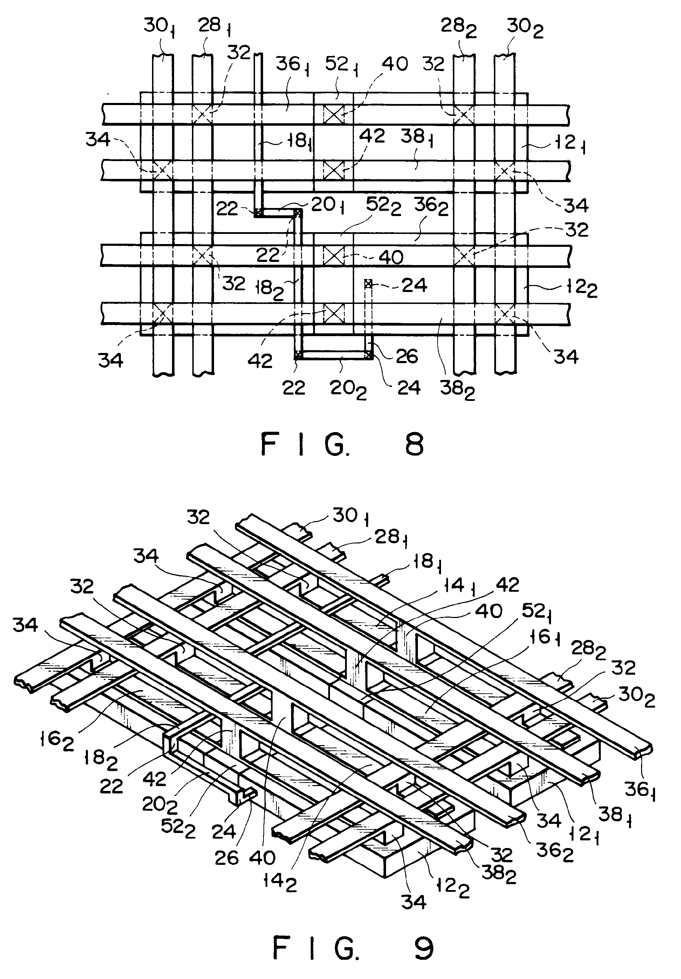

Figs. 8 and 9 show a semiconductor integrated circuit device of a standard cell system according to an embodiment of the present invention, in which Fig. 8 is a plan view, and Fig. 9 is a three-dimensional view of the device in Fig. 8. Note that the same reference numerals in Figs. 8 and 9 denote the same elements in the above-mentioned systems, and a description thereof will be omitted.

In this embodiment, each standard cell is arranged at an optimal position as a result of an automatic placement and routing operation using a computer. Dummy cells 52₁ and 52₂ without logical functions are previously buried in positions, at which via holes 40 and 42 will be formed, of each standard cell which constitutes standard cell arrays 12₁ and 12₂. In other words, the dummy cells 52₁ and 52₂ are arranged to assure positions at which the via holes 40 and 42 will be formed, the via holes 40 and 42 respectively connecting first Vcc power supply lines 14₁ and 14₂ to second Vcc power supply lines 36₁ and 36₂, and first GND power supply lines 16₁ and 16₂ to second GND power supply lines 38₁ and 38₂. Each of the dummy cells 52₁ and 52₂ arranged at the corresponding optimal position upon the automatic placement and routing operation using the computer.

Note that the first signal lines formed of the second Aℓ layer cannot be arranged above the dummy cells 52₁ and 52₂. The opening position is desirably located in a substantially central position of the standard cell arrays 12₁ and 12₂. A plurality of dummy cells can be formed to connect the first Aℓ layer to the third Aℓ layer, as a matter of course.

The first Aℓ layer is directly connected to the third Aℓ layer through the via holes in this embodiment. However, as shown in Fig. 7, the first Aℓ layer may be connected to the third Aℓ layer such that the second Aℓ layer is formed after the first via hole is formed, the second via hole is formed in the second Aℓ layer, and the third Aℓ layer is formed, as a matter of course.

Reference signs in the claims are intended for further understanding and shall not limit the scope.

## Claims

1. A semiconductor integrated circuit device of a standard cell system, comprising a cell array (12₁,12₂) constituted by a linear arrangement of a plurality of cells having a predetermined unit logical function in a semiconductor substrate;
a first power supply line (14₁,14₂;16₁,16₂) connected to each of said cells to supply a power supply voltage (Vcc, GND) to said each cell in said cell array, and formed of a first conductor layer extending in a first direction along said cell array;
a second power supply line (28₁,28₂;30₁,30₂) electrically connected to said first power supply line (14₁,14₂;16₁,16₂) and formed of a second conductor layer on said first power supply line extending in a second direction perpendicular to said first power supply line;
a third power supply line (36₁,36₂;38₁,38₂) electrically connected to said first power supply line (14₁,14₂;16₁,16₂) to supply said power supply voltage to each of said cells in said cell array (12₁,12₂), and formed of a third conductor layer on said second conductor layer extending in a third direction identical to said first direction;
a first via hole (32,34) connecting said first and second power supply lines (14₁,14₂;16₁,16₂;28₁,28₂;30₁,30₂), arranged at an end portion of said cell array (12₁,12₂) and a second via hole (40,42) connecting said first and third power supply lines (14₁,14₂;16₁,16₂;36₁,36₂;38₁,38₂) arranged at a central portion of said cell array (12₁,12₂); wherein
said cell array (12₁,12₂) includes at least one dummy cell (52₁,52₂) without a predetermined unit logical function and said second via hole (40,42) is arranged above said dummy cell (52₁,52₂).

2. A device according to claim 1, wherein
said first power supply line (14,16) is directly connected to said second power supply lines (28,30), and said third power supply lines (36,38).

3. A device according to claim 1, wherein
said first via hole (32,34) directly connects said second power supply line (28,30), to said first power supply line (14,16), and said second via hole comprises a third via hole directly connecting said third power supply line (36,38) to said second power supply line (28,30) and a fourth via hole (48,50) directly connecting said second power supply line (28,30) to said first power supply line (14,16).

## Patentansprüche

1. Integrierte Halbleiter-Schaltungsvorrichtung eines Standardzellensystems, enthaltend:
ein Zellenfeld (12₁, 12₂), das durch eine lineare Anordnung mehrer Zellen mit vorbestimmter Einheitslogikfunktion in einem Halbleitersubstrat gebildet wird;
eine erste Stromversorgungsleitung (14₁, 14₂; 16₁, 16₂), die mit jeder der Zellen zum Zuführen einer Stromversorgungsspannung (V_{cc}, GND) zu jeder Zelle in dem Zellenfeld verbunden ist und aus einer ersten Leiterschicht gebildet ist, die sich in einer ersten Richtung entlang dem Zellenfeld erstreckt;
eine zweite Stromversorgungsleitung (28₁, 28₂; 30₁, 30₂), die elektrisch mit der ersten Stromversorgungsleitung (14₁, 14₂; 16₁, 16₂) und auf einer zweiten Leiterschicht oberhalb der ersten Stromversorgungsleitung gebildet ist und sich in einer zweiten Richtung erstreckt, die rechtwinklig zu der ersten Stromversrogungsleitung verläuft;
eine dritte Stromversorgungsleitung (36₁, 36₂; 38₁, 38₂), die elektrisch mit der ersten Stromversorgungsleitung (14₁, 14₂; 16₁, 16₂) zum Zuführen der Stromversorgungsspannung zu jeder der Zellen in dem Zellenfeld (12₁, 12₂) verbunden ist und aus einer dritten Leiterschicht oberhalb der zweiten Leiterschicht gebildet ist, die sich in eine dritte Richtung erstreckt, die mit der ersten Richtung übereinstimmt;
eine erste Durchgangsöffnung (32, 34) zum Verbinden der ersten und zweiten Stromversorgungsleitungen (14₁, 14₂; 16₁, 16₂; 28₁, 28₂; 30₁, 30₂), die an einem Endabschnitt des Zellenfeldes (12₁, 12₂) angeordnet ist, und eine zweite Durchgangsöffnung (40, 42) zum Verbinden der ersten und dritten Stromversorgungsleitungen (14₁, 14₂; 16₁, 16₂; 36₁, 36₂; 38₁, 38₂), die in einem zentralen Abschnitt des Zellenfeldes (12₁, 12₂) angeordnet ist; wobei
das Zellenfeld (12₁, 12₂) mindestens eine Dummy-Zelle (52₁, 52₂) ohne vorbestimmte Einheitslogikfunktion enthält und die zweite Durchgangsöffnung (40, 42) oberhalb der Dummy-Zelle (52₁, 52₂) angeordnet ist.

2. Vorrichtung nach Anspruch 1, dadurch gekennzeichnet, daß die erste Stromversorgungsleitung (14, 16) direkt mit den zweiten Stromversorgungsleitungen (28, 30) und den dritten Stromversorgungsleitungen (36, 38) verbunden ist.

3. Vorrichtung nach Anspruch 1, dadurch gekennzeichnet, daß die erste Durchgangsöffnung (32, 34) die zweite Stromversorgungsleitung (28, 30) direkt mit der ersten Stromversorgungsleitung (14, 16) verbinden und daß die zweite Durchgangsöffnung eine dritte Durchgangsöffnung aufweist, die die dritte Stromversorgungsleitung (36, 38) direkt mit der zweiten Stromversorgungsleitung (28, 30) verbindet, sowie eine vierte Durchgangsöffnung (48, 50), die die zweite Stromversorgungsleitung (28, 30) direkt mit der ersten Stromversorgungsleitung (14, 16) verbindet.

## Revendications

1. Dispositif à circuit intégré à semi-conducteur d'un système à cellules standards comprenant une rangée de cellules (12₁, 12₂,) constituée par un agencement linéaire de plusieurs cellules ayant une fonction logique unitaire prédéterminée dans un substrat semi-conducteur ;
une première ligne d'alimentation (14₁, 14₂ ; 16₁, 16₂) connectée à chacune desdites cellules pour délivrer une tension d'alimentation (Vcc, GND) à chacune desdites cellules de ladite rangée de cellules, et formée d'une première couche conductrice s'étendant dans une première direction le long de ladite rangée de cellules;
une seconde ligne d'alimentation (28₁, 28₂ ; 30₁, 30₂) connectée électriquement à ladite ligne première d'alimentation (14₁, 14₂ ; 16₁, 16₂), et formée d'une deuxième couche conductrice sur ladite première ligne d'alimentation, s'étendant dans une deuxième direction perpendiculaire à ladite première ligne d'alimentation ;
une troisième ligne d'alimentation (36₁, 36₂ ; 38₁, 38₂) connectée électriquement à ladite première ligne d'alimentation (14₁, 14₂ ; 16₁, 16₂) pour délivrer ladite tension d'alimentation à chacune desdites cellules de ladite rangée de cellules (12₁, 12₂), et formée d'une troisième couche conductrice sur ladite deuxième couche conductrice, s'étendant dans une troisième direction identique à ladite première direction;
un premier trou traversant (32, 34) connectant lesdites première et seconde lignes d'alimentation (14₁, 14₂ ; 16₁, 16₂ ; 28₁, 28₂ ; 30₁, 30₂), agencé au droit d'une partie d'extrémité de ladite rangée de cellules (12₁, 12₂); et
un second trou traversant 40, 42) connectant lesdites première et troisième lignes d'alimentation (14₁, 14₂ ; 16₁, 16₂ ; 36₁, 36₂ ; 38₁, 38₂), agencé au droit d'une partie centrale de ladite rangée de cellules (12₁, 12₂) ; dans lequel
ladite rangée de cellules (12₁, 12₂) comprend au moins une cellule fictive (52₁, 52₂) sans fonction logique unitaire prédéterminée, et dans lequel ledit second trou traversant (40, 42) est disposé au-dessus de ladite cellule fictive (52₁, 52₂).

2. Dispositif selon la revendication 1, dans lequel : ladite première ligne d'alimentation (14, 16) est connectée directement auxdites secondes lignes d'alimentation (28, 30), et auxdites troisièmes lignes d'alimentation (36, 38).

3. Dispositif selon la revendication 1, dans lequel :
ledit premier trou traversant (32, 34) relie directement ladite seconde ligne d'alimentation (28, 30) à ladite première ligne d'alimentation (14, 16), et dans lequel ledit second trou traversant comprend, un troisième trou traversant reliant directement ladite troisième ligne d'alimentation (36, 38) à ladite seconde ligne d'alimentation (28, 30) et un quatrième trou traversant (28, 50) reliant directement ladite seconde ligne d'alimentation (28, 30) à ladite première ligne d'alimentation (14, 16).
